# FASCICULE DE BREVET EUROPEEN

(11) **EP 2 612 352 B1**
(45) Date de publication et mention de la délivrance du brevet: **30.07.2014**
(21) Numéro de dépôt: 11748936.9
(22) Date de dépôt: 24.08.2011
(51) Int. Cl.: H01L 21/762

(54) **PROCÉDÉ DE RÉALISATION D'UN FILM, PAR EXEMPLE MONOCRISTALLIN, SUR UN SUPPORT EN POLYMÈRE**
VERFAHREN ZUR HERSTELLUNG EINER FOLIE, ETWA EINER EINKRISTALLFOLIE, AUF EINEM POLYMERSUBSTRAT
PROCESS FOR PRODUCING A FILM, FOR EXAMPLE A SINGLE-CRYSTAL FILM, ON A POLYMER SUBSTRATE

(30) Priorité: 30.08.2010 FR 1056863
(43) Date de publication de la demande: 10.07.2013
(73) Titulaire: Commissariat à l'Énergie Atomique et aux Énergies Alternatives, 75015 Paris (FR)
(72) Inventeur: MORICEAU, Hubert, F-38120 Saint Egreve (FR); ARGOUD, Maxime, F-69003 Lyon (FR); MORALES, Christophe, F-38220 Saint Pierre de Mesage (FR); ZUSSY, Marc, F-38120 Saint Egreve (FR)
(74) Mandataire: Colombo, Michel
(86) Numéro de dépôt international: PCT/EP2011/064587
(87) Numéro de publication internationale: WO 2012/028518

(56) Documents cités:
- FR-A1- 2 895 419
- FR-A1- 2 913 815

## Description

### Domaine de l'invention

L'invention concerne un procédé de réalisation d'un film mince, par exemple en silicium avantageusement monocristallin, sur un support de polymère.

Parmi les principaux avantages qu'apporte l'utilisation d'un polymère comme couche de support, on peut citer :
■ La simplification des traitements de surface à réaliser dans d'éventuelles étapes de collage,
■ Le faible coût du matériau et de ses étapes de dépôt ou de collage,
■ Une forte adhérence dès les basses températures,
■ Une bonne capacité de démontage (c'est-à-dire de décollement) par traitement spécifique du polymère...

Or, l'obtention d'un tel film mince, d'épaisseur typiquement inférieure à une dizaine de micromètres, sur un support en polymère se révèle actuellement difficile à obtenir dès lors qu'on cherche à obtenir un film :
- monocristallin,
- fin,
- homogène en épaisseur, y compris sur de grandes dimensions latérales (typiquement de plusieurs centimètres carrés),
- pouvant être processé (c'est-à-dire pouvant subir des étapes de formation de composants, notamment micro- (ou nano-) électriques, micro- (ou nano-) optiques, micro- (ou nano-) mécaniques, etc. Les étapes de formation sont, par exemple, des étapes de gravure ou de dépôt).

Il convient de noter qu'il y a de nombreux matériaux qui ne peuvent pas être déposés sur un support de polymère, par exemple pour des raisons de contraintes thermiques (on comprend qu'il faut que le polymère puisse supporter le traitement de dépôt considéré, alors que, selon les matériaux, notamment dans le domaine des matériaux semi-conducteurs, un dépôt peut ne pas pouvoir se faire à des températures inférieures à plusieurs centaines de degrés Celsius.

### Etat de la technique

Compte tenu de ce qui précède, une manière actuelle de réaliser un film en silicium monocristallin sur un support de polymère consiste à coller un substrat de silicium à un support de polymère et à amincir par voie mécanique ou mécanico-chimique le substrat en silicium jusqu'à ne laisser subsister que l'épaisseur voulue. Mais le film ainsi obtenu :
- n'a pas une bonne homogénéité d'épaisseur, en particulier sur de grandes surfaces (il n'est pas possible en pratique de définir une référence par rapport à la face arrière du support en polymère),
- est difficilement manipulable lors, par exemple, d'étapes de réalisation de composants sur ce film de silicium, car le support de polymère peut être trop souple pour pouvoir être saisi par un outil de préhension d'équipement,
- présente une défectivité très élevée en bord de substrat.

Pour éviter les problèmes liés à l'étape d'amincissement, une autre façon de procéder consiste à coller une structure déjà réalisée (c'est-à-dire, de manière générale, un empilement de couches, dont le futur film), typiquement de type « silicium sur isolant » (ou « Silicon On Insulator » ou SOI en abrégé), sur un support en polymère et à retirer le support initial du SOI en se servant de la couche d'oxyde enterrée comme couche sacrificielle ou couche d'arrêt de gravure. On obtient ainsi, effectivement, un film d'épaisseur homogène (définie par l'homogénéité initiale du film superficiel du SOI), mais le film obtenu :
- a un prix de revient important en raison du coût important du procédé ainsi mis en oeuvre,
- peut, comme précédemment, être difficilement manipulable au cours d'étapes ultérieures de réalisation de composants, puisque, comme précédemment, le support en polymère peut être trop souple pour pouvoir être manipulé par un outil de préhension d'équipement.

De l'état de la technique est également connu de FR2 913 815 A1 et FR 2 895 419.

### Présentation de l'invention

Il subsiste donc le besoin d'un procédé permettant l'obtention d'un film mince d'un matériau, tel que du silicium avantageusement monocristallin, sur un support de polymère qui permette d'obtenir une grande constance de l'épaisseur, même pour de grandes surfaces de film, selon une configuration permettant des étapes de traitement (réalisation de composants, dépôt d'autres couches, etc.), pour un coût modéré.

L'invention propose à cet effet un procédé d'obtention d'un film en un premier matériau sur un support en polymère conforme à la revendication 1.

On comprend que, après le remplissage de la cavité, on dispose d'une portion de plaque qui est mixte, sensiblement plane, comportant au moins une zone formée de la couche de polymère sur la zone de fond et une zone périphérique.

De manière avantageuse, la plaque supérieure comporte, en dehors de la zone périphérique, au moins une zone, moins creusée que ladite cavité (il peut s'agir d'une zone non creusée) en formant un îlot ou un mur longé par la cavité. On peut définir ici la notion d'îlot ou de mur comme représentant une zone longée par au moins deux zones de cavité distinctes, en communication ou non. Une autre manière d'exprimer cette caractéristique avantageuse consiste à dire que, de manière avantageuse, une cavité ménagée dans la première plaque comporte au moins une zone moins creusée que le reste de la cavité, voire non creusée, formant par exemple un îlot, un pilier ou un mur provenant de la première plaque, la couche de polymère longeant cet îlot ou ce mur (dans le cas d'un îlot, on comprend que lesdites zones de cavité communiquent l'une avec l'autre, à la différence du cas d'un mur, ou lesdites zones appartiennent à des cavités a priori distinctes.

De manière également avantageuse, on creuse au moins deux cavités de profondeurs différentes.

De manière préférée, l'une au moins des plaques comporte, à proximité de l'interface de collage, une couche processée.

De manière avantageuse, avant élimination de la seconde plaque, on rectifie la couche de polymère et/ou la première plaque ; on obtient ainsi une portion de plaque mixte sensiblement plane comportant au moins une zone formée de la couche de polymère sur la zone de fond et une zone périphérique. Cette rectification peut en effet ne concerner que la plaque supérieure (avant ou après creusement de la cavité), que la couche de polymère (par exemple si elle est plus épaisse que la profondeur de la cavité considérée, voire les deux.

De manière avantageuse, l'élimination de la seconde plaque est réalisée par démontage de l'interface de collage.

De manière également avantageuse, l'élimination de la seconde plaque est réalisée par attaque sélective d'une couche sacrificielle prévue dans l'une des plaques à proximité de l'interface.

De manière également avantageuse, l'élimination de la seconde plaque est partielle, étant réalisée en sorte de conserver, avec la zone de fond, une couche superficielle de la seconde plaque.

De manière préférée, en une étape préalable, antérieure à l'étape de collage, on forme une couche enterrée dans cette seconde plaque, et l'élimination partielle de la seconde plaque est obtenue par séparation au niveau de cette couche enterrée

La zone enterrée peut être obtenue par implantation d'au moins une espèce gazeuse formant une zone de fragilisation enterrée et dans ce cas, la séparation pourra être obtenue par l'application d'efforts mécaniques et/ou thermiques

La zone enterrée peut en variante être constituée par une zone poreuse (par exemple du silicium poreux) ; une telle zone poreuse peut être considérée comme étant également une zone fragile. Dans ce cas, la séparation sera obtenue par l'application d'efforts mécaniques au niveau de cette couche enterrée.

Selon une autre variante, la couche enterrée est une couche sacrificielle, qui sera éliminée au moment de la séparation par une technique appropriées, par exemple par gravure chimique sélective.

De manière avantageuse, après l'étape de creusement et avant l'étape de remplissage de la cavité, on applique un traitement de relaxation des contraintes.

De manière avantageuse, la couche de polymère ne remplit la cavité que sur une partie de son épaisseur.

De manière préférée, l'épaisseur du film porté par le support de polymère est d'au plus 100 micromètres, et ses dimensions transversales sont au moins égales à un centimètre. En effet, en dessous d'une telle épaisseur, il devient difficile de manipuler une couche de silicium de 200mm de diamètre sans recours à un support spécifique, ici constitué par la couche de polymère.

De manière également préférée, l'épaisseur de la zone de fond est comprise entre 5 micromètres et 100 micromètres. En fait, l'épaisseur du film peut n'être formée qu'en partie de la zone de fond.

De manière préférée, chaque cavité est entourée par un rebord d'au moins une dizaine de micromètres de largeur.

De manière avantageuse, on applique au film au moins une étape de traitement puis on sépare la portion de plaque mixte vis-à-vis de la zone périphérique.

De manière préférée, le premier matériau est monocristallin.

Le premier matériau, souvent de type semiconducteur, peut notamment être du silicium ou un autre élément de la colonne IVA du tableau périodique des éléments ou un alliage de ceux-ci (par exemple SiGe), mais aussi un alliage d'éléments des colonnes IIIA-VA (tels que AsGa ou InP), voire des colonnes IIA-VIA ; il peut s'agir également d'alliage de ces matériaux. Ce matériau peut également être dopé.

### Description des figures

Des objets, caractéristiques et avantages de l'invention ressortent de la description qui suit, donnée à titre d'exemple illustratif non limitatif, en regard des dessins annexés sur lesquels :
- la figure 1 est un schéma de principe de l'empilement de deux plaques,
- la figure 2 en est un autre schéma de principe après creusement d'une cavité dans la plaque supérieure,
- la figure 3 en est un autre schéma après remplissage de la cavité avec un matériau polymère au dessus du niveau de la plaque supérieure (en pointillé, on a représenté une variante où le niveau de remplissage du matériau polymère est tel que celui-ci ne remplit pas intégralement la cavité),
- la figure 4 en est un autre schéma après rectification (optionnelle) de la couche de polymère et/ou de la partie périphérique, non creusée, de la plaque supérieure et élimination de la plaque inférieure,
- la figure 5 en est un autre schéma après élimination de la partie périphérique, non creusée, de la plaque supérieure,
- la figure 6 en est un autre schéma après réduction (optionnelle) de l'épaisseur de la zone de fond,
- la figure 7 est un schéma d'un autre empilement de deux plaques, similaire à celui de la figure 1,
- la figure 8 en est un schéma après creusement de deux cavités, dont l'une est annulaire,
- la figure 9 en est un schéma après remplissage de ces cavités avec un matériau polymère,
- la figure 10 en est un autre schéma après élimination de la plaque inférieure,
- la figure 11 en est un autre schéma après réduction d'épaisseur de la zone de fond,
- la figure 12 en est une vue de dessus,
- la figure 13 est une vue de dessus d'un autre plaque comportant un réseau de cavités rectangulaires,
- la figure 14 est un schéma d'encore un autre empilement de deux plaques, dont la plaque supérieure comporte, près de l'interface, une couche processée,
- la figure 15 en est un schéma après creusement d'une cavité et remplissage de cette cavité,
- la figure 16 en est un schéma après rectification optionnelle de la surface supérieure (c'est à dire de la couche de polymère et/ou de la partie périphérique, non creusée) de la plaque supérieure,
- la figure 17 en est un schéma après élimination de la plaque inférieure,
- la figure 18 est un schéma d'encore un autre empilement de deux plaques, dont la plaque supérieure comporte, le long de l'interface, une couche sacrificielle,
- la figure 19 en est un autre schéma après creusement d'une cavité et remplissage partiel de celle-ci,
- la figure 20 en est un autre schéma après rectification,
- la figure 21 en est un autre schéma après élimination de la plaque inférieure et de la couche sacrificielle,
- la figure 22 est un schéma de principe d'encore un autre empilement de deux plaques, dont la plaque supérieure comporte une couche processée,
- la figure 23 en est un autre schéma après creusement d'une cavité dans la plaque supérieure,
- la figure 24 en est un autre schéma après remplissage et rectification de la surface supérieure de la plaque supérieure, et
- la figure 25 en est un autre schéma après élimination de la plaque inférieure sur une partie seulement de son épaisseur.

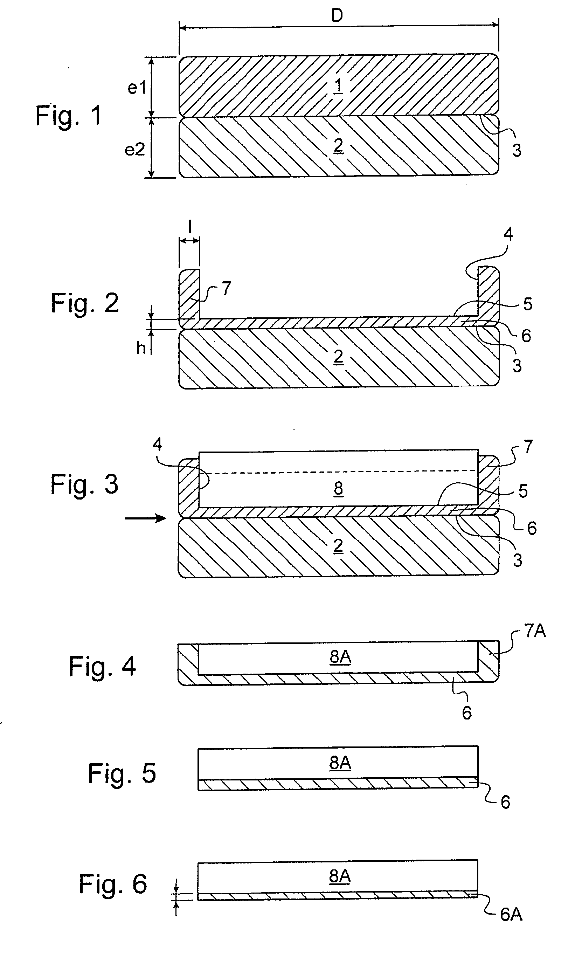

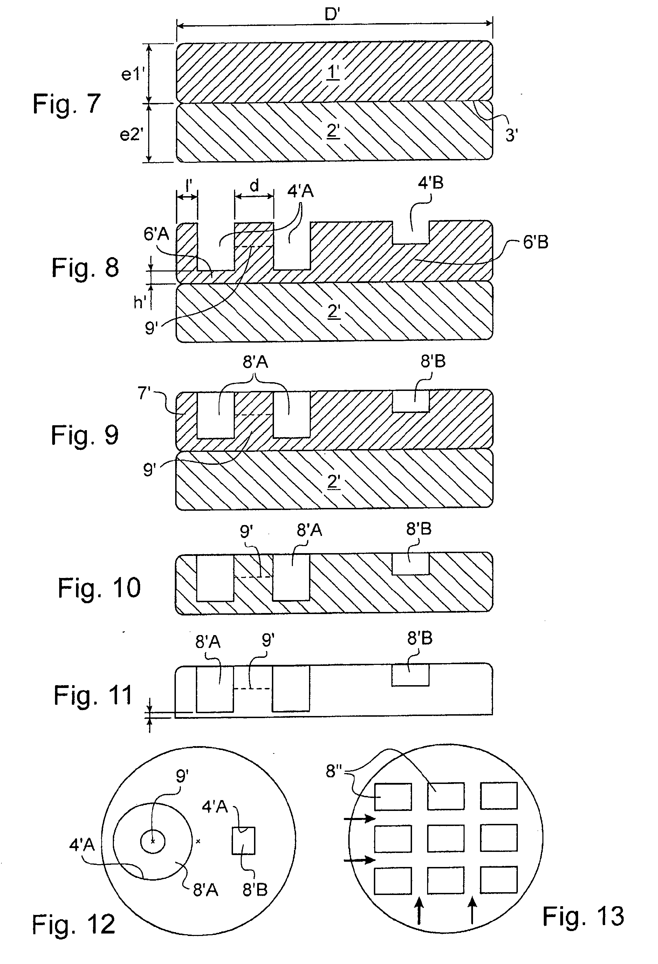

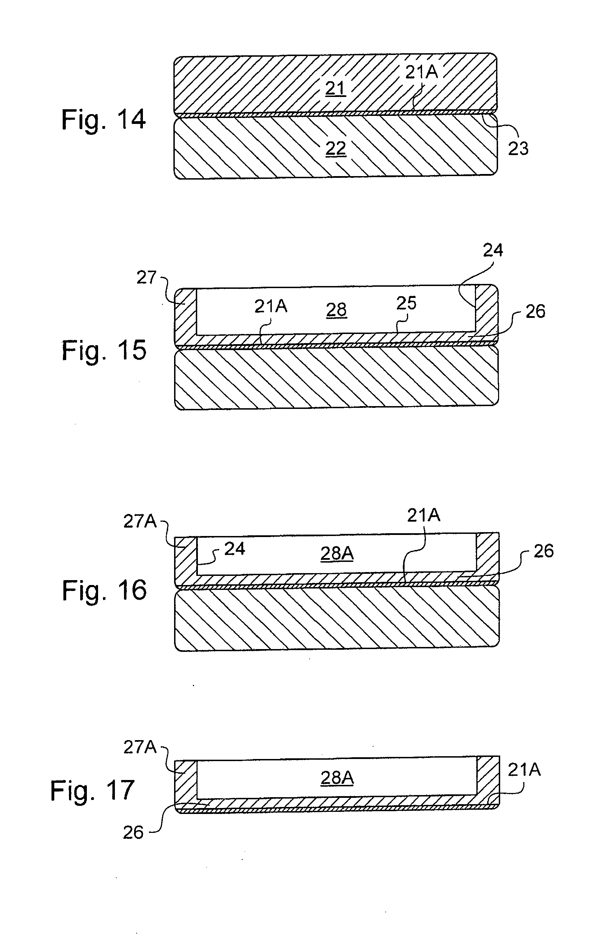

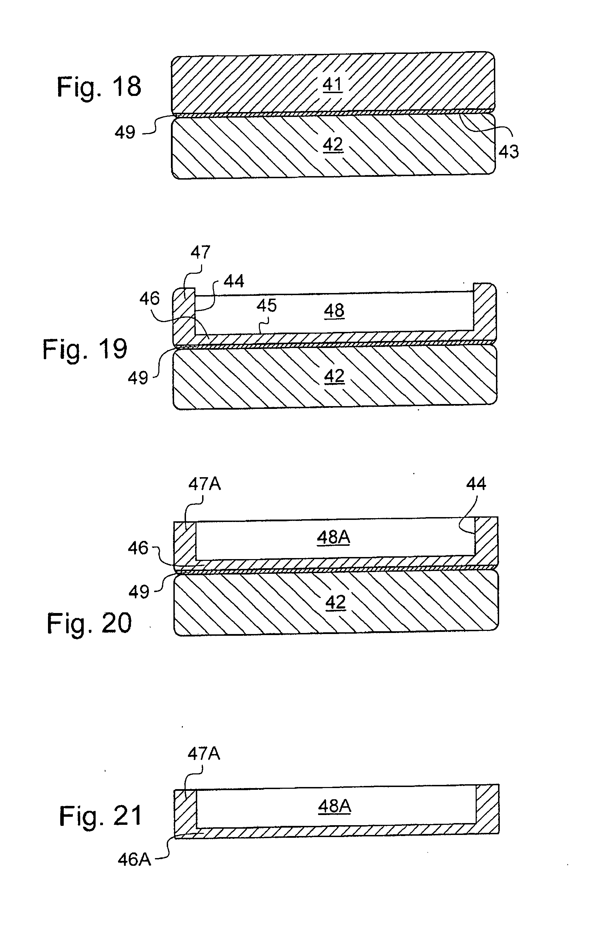

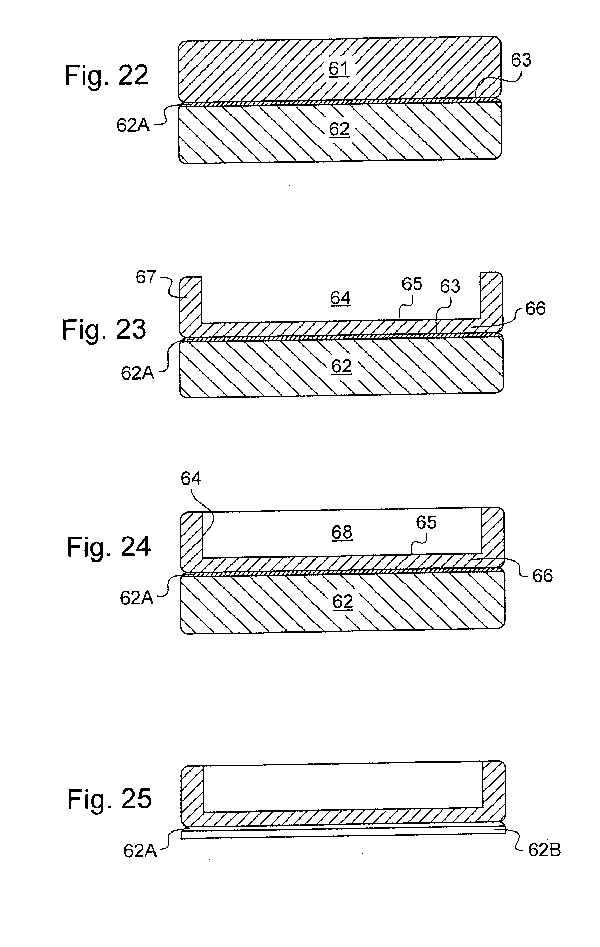

Les figures représentent divers modes de réalisation de l'invention, dont le premier (figures 1 à 6) est particulièrement simple, le second (figures 7 à 13) correspond à une géométrie de cavités plus complexe, le troisième (figures 14 à 17) correspond au cas où la plaque supérieure a été processée en surface inférieure avant collage à la plaque inférieure, le quatrième (figures 18 à 21) correspond à un cas de remplissage partiel de la cavité et une élimination partielle de la plaque supérieure et le cinquième (figures 22 à 25) correspond à un cas où la plaque inférieure n'est éliminée que sur une partie de son épaisseur. Il est clair que certaines de ces variantes peuvent être combinées, même si cela n'est pas représenté ; notamment, la plaque supérieure peut avoir été processée en face inférieure avant collage et la plaque inférieure peut n'être que partiellement éliminée...

Tous ces modes de réalisation conduisent à la formation d'un film mince de matériau sur un support de polymère, tout en conférant à l'ensemble une rigidité suffisante pour en permettre la manipulation, au cours de certaines étapes au moins, malgré la souplesse du polymère.

Les informations données ci-dessous à propos du premier mode de réalisation s'appliquent, sauf incompatibilité, aux autres modes.

### Premier mode de réalisation

Les figures 1 à 6 représentent un mode de mise en oeuvre de l'invention dans un cas particulièrement simple.

La figure 1 représente un assemblage de deux plaques 1 et 2 collées l'une à l'autre en une interface 3. Les plaques 1 et 2 utilisées sont typiquement des plaques standard utilisées en microtechnologie : elles peuvent avoir des épaisseurs constantes (même si cela n'est pas nécessaire compte tenu des étapes de rectifications possibles durant le procédé de l'invention), éventuellement égales.

La plaque supérieure 1 est destinée à former un film mince sur un support de polymère tandis que la plaque inférieure n'a principalement qu'un rôle de support. Il faut noter que le fait de dire ici qu'une plaque est supérieure ou inférieure n'a pour but que de faciliter l'exposé, mais que l'invention peut aussi être mise en oeuvre en inversant les positions des plaques.

Puisque c'est dans la plaque supérieure 1 que vont être définis le film mince (au moins en partie) et le support en polymère, cette plaque est constituée d'au moins un matériau dont on souhaite que le film mince soit formé au moins en partie.

Cette plaque 1 comporte au moins une couche dudit matériau située à proximité de l'interface de collage, le long de celle-ci ou à une faible distance de celle-ci (typiquement inférieure à 50 micromètres voire à 10 micromètres).

Dans l'exemple ici considéré, la première plaque 1 est entièrement constituée dudit matériau, par exemple du silicium. Compte tenu de l'intérêt pratique qu'il y a à obtenir des couches de silicium monocristallin sur un support de polymère, le matériau de la plaque 1 est avantageusement monocristallin.

La plaque 2 forme un support rigide. A cet effet, par exemple, la plaque 2 a une épaisseur d'au moins 5 µm et elle est réalisée dans un matériau présentant un module de Young supérieur à 10 Gpa à 25°C.

La constitution de la seconde plaque 2 peut être choisie arbitrairement. Cette plaque peut être constituée du même matériau que la première plaque 1 (sans être nécessairement monocristalline) si l'on souhaite que l'assemblage des deux plaques soit bien homogène, notamment du point de vue dilatation thermique. Toutefois bien d'autres matériaux peuvent être utilisés, par exemple du verre. Avantageusement, si des étapes de rectification sont prévues en se servant de cette plaque comme référence, on choisira pour cette plaque inférieure une bonne uniformité d'épaisseur, avec typiquement une tolérance en variation d'épaisseur (TTV - total thickness variation, en anglais) inférieure au micromètre.

Les plaques ont typiquement plusieurs dizaines, voire centaines, de micromètres d'épaisseur, avec une dimension transversale pouvant être de plusieurs centimètres, voire dizaines de centimètres. Dans l'exemple ici considéré, les épaisseurs e1 et e2 des plaques 1 et 2 sont égales l'une à l'autre, avec une valeur de 725 micromètres ; quant à la dimension transversale, qui est un diamètre D lorsque les plaques sont des disques, elle est de 200 mm. On comprend aisément que d'autres formes sont possibles, notamment ovale, rectangulaire, polygonale, etc. D'autres gammes de dimensions sont bien entendu possibles.

Le collage des deux plaques peut être un collage moléculaire (aussi appelé collage direct) ; il est avantageusement réalisé en sorte de pouvoir être démonté (on parle d'un collage direct « faible ») ; en variante, il peut s'agir d'un collage par adhésif, ou par fusion (« fusion bonding » en anglais), etc.

La figure 2 représente une étape consistant à creuser une cavité 4 dans la première plaque 1. Le fond 5 de cette cavité définit une zone de fond 6 qui est à une distance contrôlée vis-à-vis de la seconde plaque 2, qu'il s'agisse de la surface inférieure de celle-ci ou de l'interface de collage 3.

Lorsque la première plaque ne comporte le matériau souhaité que dans une couche située près de l'interface, la profondeur de la cavité est choisie en sorte que cette couche soit (sur au moins une partie de son épaisseur) dans la zone de fond 6.

L'épaisseur h de la zone de fond est choisie en fonction à la fois de l'épaisseur du film souhaité et des étapes ultérieures ; elle est typiquement de quelques dizaines de micromètres (40 micromètres dans l'exemple ici considéré mais d'autres valeurs peuvent être prévues telles que 100 micromètres, ou 25, voire 10 ou même 5 micromètres). Quant à la cavité, elle est bordée par une zone périphérique 7 de la première plaque 1 dont la largeur l est également typiquement de quelques millimètres voire quelques dizaines de millimètres (25 millimètres, dans l'exemple ici considéré, voire 10 millimètres). En pratique cette largeur est choisie, en fonction des autres dimensions de la plaque 1 et de la profondeur de la cavité, pour constituer un rebord (annulaire lorsque la plaque est en forme de disque) suffisant pour conférer à la plaque mixte obtenue à la figure 4 une rigidité suffisante pour qu'elle puisse être manipulée sans se déformer de manière excessive.

La forme de la cavité est avantageusement la même que celle de la plaque (par exemple circulaire si la plaque est elle-même circulaire), mais on comprend aisément que la forme de la cavité peut être choisie indépendamment de celle de la plaque 1 ; en outre, la cavité est ici centrée par rapport à la plaque, ce qui n'est nullement nécessaire (voir l'exemple des figures 7 à 13).

La cavité peut être formée par tout procédé connu approprié, par exemple par rectification (grinding en anglais), ou par gravure chimique (à base de KOH par exemple dans le cas du silicium), ou par gravure sèche, gravure plasma profonde, ablation laser, ablation ultrasonique, etc. - cette étape de creusement comporte si nécessaire, la formation d'un masque de gravure selon les techniques standard connues de l'homme du métier).

Le procédé TAIKO développé par la société DISCO est particulièrement adapté pour réaliser une cavité circulaire par rectification. Dans ce procédé, la structure à évider est aspirée sur une céramique poreuse à l'aide d'une pompe à vide afin d'assurer son maintien pendant la rectification et garantir une bonne homogénéité de creusement. Pour évider la structure, on utilise une meule de rectification de diamètre inférieure au rayon de la structure à évider. Par exemple, pour une structure de 200mm de diamètre, on pourra utiliser une meule TAIKO de 98mm de diamètre et ainsi réaliser une cavité de l'ordre de 188 à 198mm de diamètre. La meule est montée sur un mandrin (spindle en anglais) entraîné en rotation, la structure étant également elle-même en rotation. Le contrôle de l'épaisseur de l'évidement se fait par contrôle de la descente du mandrin à l'aide d'une vis sans fin.

Ce procédé permet d'obtenir, selon les besoins, des cavités de différents diamètres en fonction du diamètre de la meule utilisée ; il permet également, en décalant le centre de la meule par rapport à celui de la structure en rotation, d'obtenir des cavités annulaires (cf. figures 7 à 13).

Cette étape de creusement peut être accompagnée d'un traitement, par exemple dans un bain d'hydroxyde de tetraméthyl-ammonium (TMAH) à 70° pendant 1 heure dans le cas du silicium, visant à réduire les endommagements éventuels et les contraintes internes au sein de la première plaque du fait du creusement de la cavité.

Diverses étapes de procédé (non représentées) peuvent alors être effectuées lorsqu'elles nécessitent l'accès à la zone de fond 6 à partir du fond de la cavité (gravure, implantation ionique, traitement thermique, dépôt,...) Ces étapes peuvent être réalisées sur tout ou partie du fond de la cavité.

La figure 3 représente une étape ultérieure consistant à remplir, au moins en partie, la cavité avec un polymère 8 dont le matériau est celui du support en polymère sur lequel on veut obtenir un film mince. On peut noter que la masse 8 peut déborder de la cavité (l'exemple des figures 18 à 21 montrera que, au contraire, cette masse peut aussi ne pas occuper tout le volume de la cavité, ce qu'illustre également le pointillé sur la figure 3). En cas de débordement ou de retrait, une étape de rectification pourra éventuellement être prévue, comme illustré à la figure 4 pour ramener la surface du polymère au niveau de la zone périphérique non creusée de la plaque 1.

Une telle étape de rectification n'est toutefois qu'optionnelle dans la mesure où, notamment, les conditions de formation de la couche de polymère peuvent être suffisantes pour garantir un contrôle suffisant de l'épaisseur de cette couche, en particulier de sa constance.

Selon la nature du polymère considéré, cette étape de remplissage comporte une sous-étape de séchage ou de réticulation. De manière avantageuse, ce polymère est une résine thermodurcissable (éventuellement à la température ambiante), mais d'autres types de polymères, voire de matériaux sont possibles. Il s'agit par exemple de PDMS (polydiméthyl siloxane, c'est-à-dire un polymère siliconé).

La figure 4 représente le résultat de l'étape optionnelle (voir ci-dessus) de rectification au cours de laquelle on égalise l'épaisseur de la première plaque ; pour ce faire on peut prendre la face inférieure de la seconde plaque 2 comme référence. Notamment lorsque le polymère est en retrait par rapport à la cavité (voir l'exemple des figures 18 à 21), cette étape n'est pas nécessaire puisque, notamment, la zone périphérique non creusée de la plaque 1 peut suffire pour assurer une préhension par des moyens standards de préhension. Cette figure 4 représente en outre le résultat d'une étape d'élimination de cette seconde plaque.

Cette rectification, par tout procédé connu approprié peut se traduire par une réduction d'épaisseur à la fois de la masse de polymère 8 (après rectification, elle est désignée sous la référence 8A) et du rebord 7 (après rectification, il est désigné sous la référence 7A), en fonction de l'épaisseur souhaitée pour le support polymère du futur film.

Quant à l'élimination de la seconde plaque, elle peut se faire par attaque de la totalité de cette seconde plaque. Toutefois, de manière avantageuse, le collage entre les deux plaques a été réalisé sous une forme réversible, c'est-à-dire que le collage a été réalisé en sorte d'être démontable. Le démontage peut être réalisé par insertion, au niveau de l'interface de collage, d'un outil en coin, ou d'un fil, ou d'un jet de fluide sous pression (cela est schématisé par une flèche à gauche de la figure 3) ; dans un tel cas, la seconde plaque peut être réutilisée lors d'un nouveau cycle de mise en oeuvre de l'invention. On retrouve cet avantage si la seconde plaque est éliminée par séparation au niveau d'une couche enterrée prévue à cet effet (couche fragilisée, par exemple par implantation ou par porosité, ou couche sacrificielle), décrite plus en détail ultérieurement.

On comprend que la structure de la figure 4 comporte un film (la zone de fond 6) solidaire d'un support de polymère 8A ; grâce au rebord périphérique 7A, cette première plaque, devenue mixte (formée à la fois du (des) matériau(x) de la plaque 1 de départ et du polymère) peut avoir une rigidité suffisante pour pouvoir être manipulée et/ou subir des étapes technologiques sans fléchir de manière excessive. Cet avantage est conservé en l'absence de rectification.

En cas de besoin, cette structure de la figure 4 peut faire l'objet d'une étape d'adaptation d'épaisseur, par exemple en réduisant l'épaisseur de la zone de fond, par attaque chimique sèche ou humide, notamment.

Cette structure de la figure 4 se prête à diverses étapes de traitement (dépôt ou collage de couche et/ou formation de tout ou partie de composants, de type capteur ou autre) de la surface mise à nu lors de l'élimination de la seconde plaque. Bien entendu, les étapes ainsi réalisées doivent être compatibles avec la présence du polymère (sinon, on peut prévoir d'effectuer certaines étapes impliquant des températures trop hautes pour le polymère en une étape antérieure au collage - voir les figures 14 à 17).

La figure 5 représente une étape ultérieure, avantageusement réalisée après que toutes les étapes de traitement du film ont été effectuées, à savoir une étape de découpe du rebord, ce qui donne un film mince sur un support de polymère (il suffit d'inverser la figure 5).

Dans la mesure où la fabrication de la structure de la figure 4 peut être réalisée en un premier endroit, avant de faire l'objet de divers traitements en un second endroit, éventuellement dans une autre entreprise que celle qui a effectué les premières étapes, il peut se passer un temps important entre les étapes des figures 1 à 4 et celle de la figure 5.

En variante, cette étape de découpe peut être remplacée ou complétée par des étapes locales de séparation de portions du film sur polymère, en fonction des besoins (voir aussi la figure 13).

La figure 6 représente une étape optionnelle consistant à appliquer un nouveau traitement d'adaptation d'épaisseur (schématisé par une double flèche verticale) du film porté par le support en polymère (après cette réduction ce film mince est noté 6A). Cette réduction supplémentaire d'épaisseur peut par exemple être réalisée par un bain de TMAH à 80° pendant 1 heure (ce qui correspond à un retrait de l'ordre de 15 à 20 micromètres de silicium - dans le cas d'une plaque de silice, ce retrait peut être réalisé par une attaque HF) ; toutefois d'autres techniques peuvent être utilisées, notamment une gravure sèche par plasma, une gravure chimique (KOH pour le silicium), une gravure ionique, une attaque chimique assistée par centrifugation (« spin etching »), un polissage mécano-chimique (CMP), un polissage à sec (« dry polishing »), etc. Cette étape, optionnelle, peut en variante être réalisée complètement dès la libération de la surface 6, notamment avant l'étape de découpe illustrée à la figure 5.

### Second mode de réalisation

Les figures 7 à 13 représentent une variante du premier mode de réalisation, avec une géométrie de cavité plus complexe. Les éléments de ces figures qui correspondent à ceux des figures 1 à 6 sont désignés par les mêmes signes de référence que dans les figures 1 à 6, mais avec un indice « prime ».

Ainsi, la figure 7 représente l'assemblage de deux plaques 1' et 2', dont la plaque supérieure est par exemple en silicium (par exemple monocristallin).

La figure 8 représente une étape de creusement qui diffère de celle de la figure 2 par le fait qu'il y a plusieurs cavités ; dans le cas représenté, il y a deux cavités, dont une cavité 4'A, à gauche, et une cavité 4'B à droite (voir aussi la figure 12).

La cavité 4'A, contrairement à la cavité 4 de la figure 2, a une forme annulaire disposée autour d'un îlot ou pilier 9' de matière de la plaque d'origine; à titre d'exemple, cette cavité et cet îlot ont des contours circulaires et l'îlot est en position médiane de la cavité ; on comprend toutefois que les formes de la cavité et de l'îlot (et leurs positions) peuvent être choisies indépendamment l'une de l'autre (polygonaux, rectangulaires, carrés, ovales, etc.).

La largeur (ou diamètre) d de l'îlot est ici de l'ordre de la largeur de l'anneau constitué par la cavité 4'A ; en variante, cet îlot peut avoir une largeur bien plus faible, par exemple inférieure à 10%, voire 1% de la dimension transversale maximale de la cavité 4'A.

Les îlots peuvent servir d'ancrage dans la future masse de polymère ; ainsi, en variante non représentée, on peut, de façon plus ou moins régulière, répartir au sein d'une zone creusée centrale occupant la quasi-totalité de la surface de la plaque 1 des piliers de matériau rigide (matériau de la plaque supérieure). Ces piliers permettent d'obtenir une bonne rigidité « verticale » du polymère tout en laissant une certaine flexibilité du polymère dans son plan. Ils peuvent aussi servir de support lors d'étapes ultérieures (en minimisant éventuellement les efforts de compression sur la masse de polymère).

La hauteur des îlots peut être inférieure à la profondeur des cavités adjacentes (cela est représenté, à titre d'exemple, par un pointillé aux figures 8 à 11).

La cavité 4'B, de contour quelconque, est ici massive (comme la cavité de la figure 2), mais sa profondeur est différente de celle de la première cavité 4'A.

Il subsiste avantageusement, tout autour de l'ensemble des cavités, un rebord dont la largeur est au moins égale en tout point à une valeur l'. par exemple de même valeur que I à la figure 2.

Diverses étapes de procédé (comme déjà décrites) peuvent à ce stade être réalisées sur tout ou partie du fond de certaines cavités à partir de l'intérieur des cavités.

La figure 9 représente le résultat obtenu après remplissage et rectification (optionnelle) de la surface supérieure de la première plaque 1' et/ou du polymère. La masse de polymère remplissant la cavité 4'A est désignée sous la référence 8'A et la masse de polymère remplissant la cavité 4'B est désignée sous la référence 8'B.

On comprend que, après élimination de la seconde plaque 2' (voir la figure 10), la plaque mixte obtenue peut être analysée comme étant formée de plusieurs portions comportant des films (c'est-à-dire les zones de fond de chaque cavité) solidaires de supports de polymère (c'est-à-dire les diverses masses de polymère). Il est rappelé ici que, pour des raisons de lisibilité des dessins, les largeurs représentées aux figures sont bien plus courtes que dans la réalité par rapport aux épaisseurs.

En pratique, en cas de pluralité de cavités, les rebords intermédiaires ou murs (entre cavités adjacentes) sont avantageusement minimisés en ce qui concerne leurs dimensions transversales. Ces murs peuvent avantageusement être utilisés ultérieurement comme chemin de découpe pour séparer les cavités les unes des autres. Dans ce cas ils sont dimensionnés et disposés pour favoriser cette découpe (à l'aide d'une scie ou d'un laser) ; des lignes de découpe sont schématisée par des flèches sur la figure 13.

Comme dans le premier exemple de réalisation, il peut y avoir un traitement d'adaptation d'épaisseur après détachement de la seconde plaque (voir la figure 11).

Ainsi que cela ressort de la figure 13, le nombre de cavités, et donc de masses de polymère, peut être bien supérieur à 2 ; dans l'exemple représenté par cette figure, il y a un réseau de cavités de mêmes formes, suivant des alignements facilitant les découpes mentionnées ci-dessus pour détacher des zones mixtes notées 8".

En variante, des variations d'épaisseur de la zone de fond peuvent être obtenues en réalisant des attaques locales au fond de la cavité 4 de la figure 2 ; de même, selon une autre variante (éventuellement combinable avec la précédente), on peut prévoir une pluralité d'îlots (ou piliers), de hauteurs quelconques, au sein de la cavité de la figure 2.

### Troisième mode de réalisation

Les figures 14 à 17 représentent une variante du premier mode de réalisation dans laquelle la première plaque a été processée en sa surface inférieure , c'est-à-dire qu'elle a déjà subi un (ou plusieurs) traitement(s) visant notamment, par exemple, à la formation de composants ou de couche, ou en sorte d'avoir une structure de type SOI (avec une couche superficielle, par exemple monocristalline séparée du reste de la plaque par une couche d'isolant) ou en sorte d'avoir une couche superficielle séparée du reste de la plaque par une couche métallique. Les éléments similaires à ceux des figures 1 à 6 sont désignés par des signes de référence se déduisant des signes de ces figures 1 à 6 par addition du nombre 20.

Ainsi la figure 14 représente un assemblage de deux plaques 21 et 22 collées l'une à l'autre en sorte de former une interface 23.

A la différence du cas de la figure 1, la plaque supérieure 21 a fait l'objet, avant l'étape de collage, d'au moins un traitement (voir ci-dessus) ; cette zone processée est schématisée par une ligne 21A. Cette zone processée comporte une couche du matériau utile, par exemple du silicium monocristallin, par exemple située entre la ligne désignée par le signe 21A et l'interface.

Comme dans le premier mode de réalisation, une cavité 24 est creusée dans la plaque supérieure, dont le fond 25 définit une zone de fond 26. Cette zone de fond contient la zone processée. Comme précédemment, cette zone peut à ce stade être processée à partir du fond de la cavité, et il peut y avoir un nombre quelconque de cavités. Cette cavité est ensuite remplie d'une masse de polymère 28 (figure 15).

Par rectification éventuelle (figure 16) on égalise les hauteurs des rebords 27 et de la portion mixte centrale (formée de la masse de polymère et de la zone de fond).

Après élimination de la plaque inférieure 22 (figure 17), par exemple par démontage de l'interface de collage, on obtient une structure comportant un film mince (formé de la zone de fond, incluant la zone processée 21A) solidaire d'un support de polymère, le tout étant rigidifié par un rebord 27.

### Quatrième mode de réalisation

Les figures 18 à 21 représentent une variante des figures 1 à 6, dans laquelle, d'une part il y a un remplissage partiel de la cavité et, d'autre part, l'élimination de la plaque inférieure ne se fait pas par démontage. Les éléments similaires à ceux des figures 1 à 6 sont désignés par des signes de référence se déduisant des signes de ces figures 1 à 6 par addition du nombre 40.

Plus précisément, la figure 18 représente un assemblage de deux plaques 41 et 42 collées l'une à l'autre au niveau d'une interface 43.

La première plaque 41 comporte en surface (donc le long de sa face inférieure) une couche sacrificielle 49, c'est-à-dire une couche capable d'être éliminée sélectivement par rapport à au moins une couche adjacente de la plaque 41. A titre d'exemple, si le reste de la plaque est en silicium, par exemple monocristallin (y compris la couche adjacente lorsque celle-ci est de nature différente du reste de la plaque), la couche sacrificielle peut être en oxyde silicium.

Cette couche 49 peut avoir d'autres fonctions, notamment celle de raidisseur, ou de couche protectrice ; cette couche peut avoir plusieurs micromètres d'épaisseur.

Cette couche 49 est représentée sous la forme d'une couche unique ; on comprend toutefois qu'elle peut être formée de plusieurs couches superposées.

En particulier, à titre d'exemple, au lieu d'être un collage direct, le collage entre cette couche sacrificielle et la plaque inférieure 42 peut impliquer une couche d'accrochage ; cette dernière peut être considérée comme faisant partie de la couche sacrificielle puisque, lors de l'étape d'élimination sélective, cette couche d'accrochage pourra être éliminée aussi vis-à-vis du reste de la première plaque 41.

Dans cette plaque supérieure 41 est creusée (figure 19) une cavité 44 bordée par un rebord 47 et dont le fond 45 délimite une zone de fond 46 incluant la couche sacrificielle ; ainsi que cela ressortira de la suite, l'épaisseur de matière entre le fond 45 et la couche sacrificielle détermine l'épaisseur du futur film qui sera porté par un support en polymère. Comme expliqué précédemment, le fond de la cavité peut à ce stade subir des étapes technologiques à partir de l'intérieur de cette cavité.

Dans cette cavité 44 est déposée une masse de polymère 48 qui, dans cet exemple, n'occupe la cavité que sur une partie de son épaisseur.

L'épaisseur de cette masse 48 est toutefois au moins égale à l'épaisseur du futur support en polymère. Une étape (optionnelle) de rectification (figure 18) peut être prévue pour ramener le rebord 47 de la plaque (repéré 47A après rectification) au niveau de la masse 48 (repérée 48A après rectification). Avantageusement, on conservera un rebord épais le temps nécessaire à la manipulation de l'ensemble via ce rebord par des outils classiques de préhension, notamment pour la réalisation d'étapes technologiques.

A la différence du premier mode de réalisation, l'élimination de la seconde plaque est réalisée, par élimination sélective de la couche sacrificielle 49 (figure 19) de la première plaque. En principe, cette élimination libère la surface supérieure de la seconde plaque, laquelle peut donc être réutilisée pour un nouveau cycle de mise en oeuvre de l'invention.

La couche sacrificielle 49 peut être par exemple un oxyde de silicium qui peut être sélectivement gravée par rapport au silicium. Il peut s'agir également d'un film de silicium amorphe déposé par PECVD. Un tel dépôt est connu pour contenir beaucoup d'hydrogène. Un traitement thermique à basse température (typiquement 400°C) permet d'induire à l'interface de collage une forte densité de bulles ou défauts de collage. Après remplissage de la cavité par le polymère, la structure peut ainsi facilement être séparée au niveau de cette interface.

Ainsi on obtient, comme dans la figure 4, un film (reliquat de la zone de fond après élimination de la couche sacrificielle, noté 46A) solidaire d'un support en polymère, le tout étant rigidifié par un rebord périphérique.

### Cinquième mode de réalisation

Les figures 22 à 25 représentent une autre variante du premier mode de réalisation dans lequel l'élimination de la seconde plaque n'est que partielle. Les éléments similaires à ceux des figures 1 à 6 sont désignés par des signes de référence se déduisant des signes de ces figures 1 à 6 par addition du nombre 60

La figure 22 représente ainsi un assemblage de deux plaques 61 et 62 collées l'une à l'autre, par exemple par collage direct.

A la différence du premier mode de réalisation, la seconde plaque 62 comporte en partie supérieure une couche utile, c'est-à-dire une couche destinée à faire partie (au moins partiellement sur sa face) du futur film que l'on souhaite rendre solidaire d'un support en polymère. Cette couche utile est désignée sous la référence 62A.

Dans la première plaque est réalisée (figure 23) une cavité 64, dont le fond 65 délimite avec l'interface 63 une zone de fond 66. Cette cavité est entourée par un rebord 67. Le fond peut éventuellement être processé, comme indiqué dans les précédents exemples.

Cette cavité est remplie (figure 24) avec une masse de polymère 68. Cette étape est suivie, si on le souhaite, par une étape de rectification (elle n'est pas représentée ici).

La figure 25 représente schématiquement le résultat d'une élimination partielle de la seconde plaque : à la première plaque reste fixé la couche utile 62A et, éventuellement, une couche sous-jacente 62B.

La réduction de la seconde plaque 62 à l'ensemble des couches 62A et 62B est obtenu par toute technique connue appropriée.

A titre d'exemple, cet ensemble des couches 62A et 62B est avantageusement délimité entre la surface supérieure de la seconde plaque et une couche fragile enterrée (par exemple obtenue par implantation d'au moins une espèce - hydrogène, hélium ou autre - qui génère des défauts fragilisant la seconde plaque à un niveau contrôlé sous la surface libre de cette première plaque) ; cette couche fragile enterrée, lorsqu'elle existe, est réalisée préalablement à l'étape de collage des deux plaques. Par application d'un traitement thermique à faible température (c'est-à-dire compatible avec la présence de la masse en polymère) ou, de préférence par application d'efforts mécaniques (en plus ou à la place d'un tel traitement thermique), on provoque la séparation entre les couches 62A+62B et le reste de la seconde plaque ; il faut comprendre que la notion d'efforts mécaniques doit être comprise dans un sens large englobant l'application d'efforts de traction, de cisaillement, de torsion, mais aussi l'application localisée d'un jet de fluide, ou d'ultrasons, etc.

En variante, l'élimination de la seconde plaque sous la couche 62A (et de la sous-couche 62B lorsqu'on la souhaite) peut aussi être obtenue par meulage mécanique, attaque chimique (éventuellement jusqu'à une couche d'arrêt prévue en face inférieure de la couche 62A ou 62B) ; un exemple de structure intégrant une telle couche d'arrêt est le SOI, l'oxyde enterré servant de couche d'arrêt. Dans une telle structure SOI, le film superficiel de silicium peut avantageusement avoir subi préalablement au collage diverses étapes technologiques (par exemple pour la réalisation de composants CMO). La seconde plaque peut en variante être formée d'un empilement de couches et la séparation peut être provoquée à une interface entre des couches de cet empilement constitutif de la seconde plaque.

On peut noter qu'à la figure 25 la structure obtenue comporte un film (formé de la superposition de la zone de fond provenant de la première plaque et d'au moins la couche utile 62A), dont il est facile de prévoir qu'au moins une partie soit dans un matériau souhaité dans ce film (soit dans la première plaque, soit dans la seconde plaque).

On comprend aisément que, si les modes de réalisation ci-dessus ont été donnés en mentionnant comme exemple le silicium, d'autres matériaux peuvent être mis en oeuvre grâce à l'invention, notamment des matériaux semiconducteurs ; il peut s'agir, notamment, de matériaux formés d'autres éléments chimiques de la colonne IVA du tableau périodique des éléments ou un alliage de ceux-ci (par exemple SiGe), mais aussi un alliage d'éléments des colonnes IIIA-VA (tels que AsGa ou InP), voire des colonnes IIA-VIA (tel Cd Te, par exemple).

Un intérêt particulier de l'invention consiste à permettre que la couche portée par un support en polymère comporte un film de matériau monocristallin, mais on comprend que la mise en oeuvre de l'invention ne se limite pas à cet aspect monocristallin.

## Revendications

1. Procédé d'obtention d'un film en un premier matériau sur un support en polymère, selon lequel,
on colle une première plaque (1, 1', 21, 41, 61) sur une seconde plaque (2, 2', 22, 42, 62) en définissant une interface de collage (3, 3', 23, 43, 63) entre ces plaques, l'une au moins de ces plaques comportant au moins une couche du premier matériau située à proximité de l'interface,
on creuse dans la première plaque au moins une cavité (4, 4'A, 4'A, 24, 44, 64) dont le fond (5, 25, 45, 65), parallèle à l'interface entre les première et seconde plaques, définit dans la première plaque une zone de fond (6, 6'A, 6'B, 26, 46, 66) en étant à une distance contrôlée vis-à-vis de la seconde plaque,
on forme une couche de polymère (8, 8'A, 8'B, 28, 48, 68) dans cette cavité sur une épaisseur contrôlée à partir de son fond, en sorte d'obtenir une portion de plaque qui est mixte, comportant une zone formée de la couche de polymère sur la zone de fond et une zone périphérique,
on élimine la seconde plaque sur au moins la majeure partie de son épaisseur, en sorte de libérer, sous la couche de polymère, un film comportant ladite couche du premier matériau.

2. Procédé selon la revendication 1, **caractérisé en ce que** la plaque supérieure comporte une zone (9') moins creusée que ladite cavité et formant un îlot ou un mur longé par la couche de polymère.

3. Procédé selon la revendication 1 ou la revendication 2, **caractérisé en ce que** l'on creuse au moins deux cavités de profondeurs différentes (4'A, 4'B).

4. Procédé selon l'une quelconque des revendications 1 à 3, **caractérisé en ce que** l'une au moins des plaques comporte, à proximité immédiate de l'interface de collage, une couche processée (21A), une couche processée étant une couche ayant subi des étapes de formation d'un micro- ou nano-composant électrique, optique ou mécanique.

5. Procédé selon l'une quelconque des revendications 1 à 4, **caractérisé en ce que**, avant élimination de la seconde plaque, on rectifie la couche de polymère et/ou la première plaque.

6. Procédé selon l'une quelconque des revendications 1 à 5, **caractérisé en ce que** l'élimination de la seconde plaque est réalisée par démontage de l'interface de collage.

7. Procédé selon l'une quelconque des revendications 1 à 5, **caractérisé en ce que** l'élimination de la seconde plaque est réalisée par attaque sélective d'une couche sacrificielle (49) prévue dans l'une des plaques à proximité de l'interface.

8. Procédé selon l'une quelconque des revendications 1 à 5, **caractérisé en ce que** l'élimination de la seconde plaque est partielle, étant réalisée en sorte de conserver, avec la zone de fond, une couche superficielle de la seconde plaque (62A, 62B).

9. Procédé selon la revendication 8, **caractérisé en ce que**, en une étape préalable, antérieure à l'étape de collage, on forme une couche enterrée dans cette seconde plaque, et l'élimination partielle de la seconde plaque est obtenue par l'application d'efforts mécaniques au niveau de la couche enterrée.

10. Procédé selon l'une quelconque des revendications 1 à 9, **caractérisé en ce que**, après l'étape de creusement et avant l'étape de remplissage de la cavité, on applique un traitement de relaxation des contraintes.

11. Procédé selon l'une quelconque des revendications 1 à 10, **caractérisé en ce que** la couche de polymère (48) ne remplit la cavité que sur une partie de son épaisseur.

12. Procédé selon l'une quelconque des revendications 1 à 11, **caractérisé en ce que** l'épaisseur du film porté par le support de polymère est d'au plus 100 micromètres, et ses dimensions transversales sont au moins égales à un centimètre.

13. Procédé selon l'une quelconque des revendications 1 à 12, **caractérisé en ce que** l'épaisseur de la zone de fond est comprise entre 5 micromètres et 100 micromètres.

14. Procédé selon l'une quelconque des revendications 1 à 13, **caractérisé en ce que** chaque cavité est entourée par un rebord (7, ', 27, 47, 67) d'au moins une dizaine de micromètres de largeur.

15. Procédé selon l'une quelconque des revendications 1 à 14, **caractérisé en ce que** l'on applique au film au moins une étape de traitement puis on sépare la portion de plaque mixte vis-à-vis de la zone périphérique.

16. Procédé selon l'une quelconque des revendications 1 à 15, **caractérisé en ce que** le premier matériau est monocristallin.

## Patentansprüche

1. Verfahren zum Erhalt einer Folie aus einem ersten Material auf
einem Polymerträger, gemäß dem
eine erste Platte (1, 1', 21, 41, 61) auf eine zweite Platte (2, 2', 22, 42, 62) geklebt wird, indem eine Verklebungszwischenfläche (3, 3', 23, 43, 63) zwischen diesen Platten definiert wird, wobei wenigstens eine dieser Platten wenigstens eine Schicht des ersten Materials nahe an der Zwischenfläche angeordnet umfasst,
in der ersten Platte wenigstens ein Hohlraum (4, 4'A, 4'A, 24, 44, 64) ausgespart wird, dessen Boden (5, 25, 45, 65) parallel zur Zwischenfläche zwischen der ersten und der zweiten Platte in der ersten Platte einen Bodenbereich (6, 6'A, 6'B, 26, 46, 66) begrenzt und sich dabei in einem kontrollierten Abstand gegenüber der zweiten Platte befindet,
in diesem Hohlraum über eine kontrollierte Dicke zu seinem Boden eine Polymerschicht (8, 8'A, 8'B, 28, 48, 68) gebildet wird, um einen Plattenabschnitt zu erhalten, der gemischt ist und einen aus der Polymerschicht auf dem Bodenbereich gebildeten Bereich sowie einen Umfangsbereich aufweist,
die zweite Platte wenigstens über den größten Teil ihrer Dicke entfernt wird, um unter der Polymerschicht eine Folie freizulegen, die die Schicht des ersten Materials aufweist.

2. Verfahren nach Anspruch 1, **dadurch gekennzeichnet, dass** die obere Platte einen Bereich (9') aufweist, der weniger ausgespart ist als der Hohlraum und eine Insel oder eine Wand bildet, an der entlang die Polymerschicht verläuft.

3. Verfahren nach Anspruch 1 oder Anspruch 2, **dadurch gekennzeichnet, dass** wenigstens zwei Hohlräume unterschiedlicher Tiefe (4'A, 4'B) ausgespart werden.

4. Verfahren nach einem der Ansprüche 1 bis 3, **dadurch gekennzeichnet, dass** wenigstens eine der Platten in unmittelbarer Nähe zur Verklebungszwischenfläche eine bearbeitete Fläche (21A) aufweist, wobei es sich bei einer bearbeiteten Schicht um eine Schicht handelt, die Schritte der Bildung einer elektrischen, optischen oder mechanischen Mikro- oder Nanokomponente durchlaufen hat.

5. Verfahren nach einem der Ansprüche 1 bis 4, **dadurch gekennzeichnet, dass** die Polymerschicht und/oder die erste Platte vor Entfernung der zweiten Platte begradigt werden.

6. Verfahren nach einem der Ansprüche 1 bis 5, **dadurch gekennzeichnet, dass** die Entfernung der zweiten Platte durch Demontieren der Verklebungszwischenfläche erfolgt.

7. Verfahren nach einem der Ansprüche 1 bis 5, **dadurch gekennzeichnet, dass** die Entfernung der zweiten Platte durch selektives Angreifen einer Opferschicht (49) erfolgt, die in einer der Platten in der Nähe der Zwischenfläche vorgesehen wird.

8. Verfahren nach einem der Ansprüche 1 bis 5, **dadurch gekennzeichnet, dass** die Entfernung der zweiten Platte partiell erfolgt und so erfolgt, dass mit dem Bodenbereich eine Oberflächenschicht der zweiten Platte (62A, 62B) erhalten wird.

9. Verfahren nach Anspruch 8, **dadurch gekennzeichnet, dass** in einem vorausgehenden Schritt vor dem Schritt des Verklebens eine in der zweiten Platte vergrabene Schicht gebildet wird und das partielle Entfernen der zweiten Platte durch Anwendung mechanischer Kräfte an der vergrabenen Schicht erzielt wird.

10. Verfahren nach einem der Ansprüche 1 bis 9, **dadurch gekennzeichnet, dass** nach dem Schritt des Aussparens und vor dem Schritt des Füllens des Hohlraums eine Behandlung zur Spannungslösung erfolgt.

11. Verfahren nach einem der Ansprüche 1 bis 10, **dadurch gekennzeichnet, dass** die Polymerschicht (48) den Hohlraum nur über einen Teil von dessen Dicke füllt.

12. Verfahren nach einem der Ansprüche 1 bis 11, **dadurch gekennzeichnet, dass** die Dicke der von dem Polymerträger getragenen Folie höchstens 100 Mikrometer beträgt und ihre Querabmessungen wenigstens einen Zentimeter betragen.

13. Verfahren nach einem der Ansprüche 1 bis 12, **dadurch gekennzeichnet, dass** die Dicke des Bodenbereichs zwischen 5 und 100 Mikrometer liegt.

14. Verfahren nach einem der Ansprüche 1 bis 13, **dadurch gekennzeichnet, dass** jeder Hohlraum von einem Rand (7, ', 27, 47, 67) mit mindestens ungefähr 10 Mikrometern Breite umgeben wird.

15. Verfahren nach einem der Ansprüche 1 bis 14, **dadurch gekennzeichnet, dass** die Folie wenigstens einem Behandlungsschritt unterzogen und dann der Teil der gemischten Platte gegenüber dem Umfangsbereich abgetrennt wird.

16. Verfahren nach einem der Ansprüche 1 bis 15, **dadurch gekennzeichnet, dass** das erste Material monokristallin ist.

## Claims

1. A method for obtaining a film in a first material from a polymer medium, according to which:
a first plate (1, 1', 21, 41, 61) is bonded onto a second plate (2, 2', 22, 42, 62) so as to define a bonding interface (3, 3', 23, 43, 63) between those plates, at least one of those plates including at least one layer of the first material situated close to the interface;
at least one cavity (4, 4'A, 4'A, 24, 44, 64) is hollowed out in the first plate, the bottom (5, 25, 45, 65) of which, parallel to the interface between the first and second plates, defines a bottom area (6, 6'A, 6'B, 26, 46, 66) in the first plate while at a controlled distance vis-a-vis the second plate;
a polymer layer (8, 8'A, 8'B, 28, 48, 68) is formed in that cavity across a thickness controlled from its bottom, so as to obtain a plate portion that is mixed, comprising an area formed of the polymer layer in the bottom area and a peripheral area;
the second plate is removed across at least the majority of its thickness, in order to release a film including the said layer of the first material under the polymer layer.

2. A method according to claim 1, **characterised in that** the upper plate includes an area (9') that is less hollowed out than the said cavity forming a small island or a wall bordered by the polymer layer.

3. A method according to claim 1 or claim 2 **characterised in that** at least two cavities of different depths (4'A, 4'B) are hollowed out.

4. A method according to any of claims 1 to 3 **characterised in that** at least one of the plates includes a processed layer (21 A), in the immediate vicinity of the bonding interface, a processed layer being a layer that has undergone phases for the formation of an electrical, optical or mechanical micro- or nano-component.

5. A method according to any of claims 1 to 4 **characterised in that**, before removing the second plate, the polymer layer and/or the first plate is leveled.

6. A method according to any of claims 1 to 5 **characterised in that** the removal of the second plate is achieved through the disassembly of the bonding interface.

7. A method according to any of claims 1 to 5 **characterised in that** the removal of the second plate is achieved through the selective etching of a sacrificial layer (49) provided for in one of the plates near to the interface.

8. A method according to any of claims 1 to 5, **characterised in that** the removal of the second plate is partial, being achieved so as to retain a surface layer of the second plate (62A, 62B) together with the bottom area.

9. A method according to claim 8, **characterised in that**, during a preliminary phase, prior to the bonding phase, an embedded layer is formed in this second plate and the partial removal of the second plate is achieved through the application of mechanical stress on reaching the embedded layer.

10. A method according to any of claims 1 to 9 **characterised in that**, after the hollowing out phase and before the cavity filling phase, a stress relaxation treatment is applied.

11. A method according to any of claims 1 to 10 **characterised in that** the polymer layer (48) only fills part of the depth of the cavity.

12. A method according to any of claims 1 to 11 **characterised in that** the thickness of the film borne by the polymer medium is no more than 100 micrometres and its horizontal dimensions are at least equal to one centimetre.

13. A method according to any of claims 1 to 12 **characterised in that** the thickness of the bottom area is between 5 micrometres and 100 micrometres.

14. A method according to any of claims 1 to 13, **characterised in that** each cavity is surrounded by a rim (7, ', 27,47, 67) measuring at least ten micrometres in width.

15. A method according to any of claims 1 to 14 **characterised in that** at least one treatment phase is applied to the film and the mixed plate portion is then separated vis-a-vis the peripheral area.

16. A method according to any of claims 1 to 15 **characterised in that** the first material is monocrystalline.
